(19) Europäisches Patentamt
European Patent Office
Office européen des brevets

(11) Veröffentlichungsnummer: **0 097 124**
**B1**

(12) **EUROPÄISCHE PATENTSCHRIFT**

(45) Veröffentlichungstag der Patentschrift: **15.10.86**

(51) Int. Cl.⁴: **G 03 C 1/68,** C 08 F 2/50, C 09 D 11/02

(21) Anmeldenummer: **83810252.3**

(22) Anmeldetag: **09.06.83**

(54) **Verfahren zur Photopolymerisation ungesättigter Verbindungen.**

(30) Priorität: **15.06.82 CH 3690/82**

(43) Veröffentlichungstag der Anmeldung: **28.12.83 Patentblatt 83/52**

(45) Bekanntmachung des Hinweises auf die Patenterteilung: **15.10.86 Patentblatt 86/42**

(84) Benannte Vertragsstaaten: **DE FR GB IT**

(56) Entgegenhaltungen: **EP-A-0 003 002**

(73) Patentinhaber: **CIBA- GEIGY AG, Klybeckstrasse 141, CH- 4002 Basel (CH)**

(72) Erfinder: **Hüsler, Rinaldo, Dr., Belchenstrasse 12, CH- 4054 BAsel (CH)**
Erfinder: **Rutsch, Werner, Dr., Avenue Weck-Reynold 1, CH- 1700 Fribourg (CH)**
Erfinder: **Dietliker, Kurt, Dr., Ave Jean- Marie Musy 6, CH- 1700 Fribourg (CH)**

**EP 0 097 124 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1986

**Beschreibung**

Die Erfindung betrifft ein Verfahren zur Photopolymerisation ungesättigter Verbindungen unter Verwendung von bestimmten Photoinitiatoren aus der Klasse der Aroylverbindungen. Es handelt sich dabei um Aryl-cycloalkenyl-ketone und Aryl-oxacycloalkenyl-ketone, die in α-Stellung zur Carbonylgruppe eine O- oder N-funktionelle Gruppe tragen. Soweit diese Verbindungen neu sind, betrifft die Erfindung auch diese Verbindungen. Die Erfindung betrifft schliesslich auch Zusammensetzungen aus photopolymerisierbaren ungesättigten Verbindungen und diesen Photoinitiatoren.

Photochemische Polymerisationsprozesse haben in der Technik erhebliche Bedeutung erlangt, vor allem in solchen Fällen, wo dünne Schichten in kurzer Zeit gehärtet werden müssen, wie z.B. bei der Härtung von Lacküberzügen oder bei Trocknung von Druckfarben. Die UV-Bestrahlung in Gegenwart von Photoinitiatoren zeigt gegenüber herkömmlichen Härtungsverfahren eine Reihe von Vorteilen, deren wichtigster wohl die hohe Geschwindigkeit der Photohärtung ist. Die Geschwindigkeit ist stark vom verwendeten Photoinitiator abhängig und es hat nicht an Versuchen gefehlt, die herkömmlichen Initiatoren durch immer bessere und wirksamere Verbindungen zu ersetzen. Zu diesen wirksamsten Photoinitiatoren gehören Aroylverbindungen wie rein aromatische Ketone (Benzophenone), Benzoine und Benzoinether oder Benzile und Benzilketale. Als sehr wirksam vurden auch aromatisch-aliphatische Ketone befunden,in deren α-Stellung sich ein tertiäres Kohlenstoffatom befindet, an dem sich eine Hydroxylgruppe oder Aminogruppe oder ein Derivat einer solchen Gruppe befindet. Das strukturelle Prinzip dieser Verbindungen könnte man mit der allgemeinen Formel

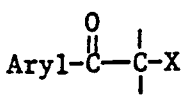

X = OH, OR, $NH_2$, NHR, $NR_2$

kennzeichnen. Hierzu gehören die in den DE-OS 27 22 264, 28 08 459 und in der EP-A 3002 beschriebenen Verbindungen. In der EP-A 3002 ist auch beschrieben, dass der aliphatische Teil der Verbindung ein Cycloalkanrest sein kann, typisch hierfür ist das dort als Verbindung Nr. 4 beschriebene 1-Benzoylcyclohexanol. Verbindungen mit einem ungesättigten cycloaliphatischen Ring sind bisher noch nicht als Photoinitiatoren beschrieben worden. Offensichtlich existierten Vorurteile gegen die Verwendung ungesättigter Verbindungen als Photoinitiatoren, beispielsweise wegen möglicher negativer Einwirkung auf den Radikalketten-Mechanismus der Polymerisationsreaktion. Tatsächlich haben olefinisch ungesättigte Verbindungen als Photoinitiatoren nie technische Bedeutung erlangt.

Es wurde nunmehr überraschend gefunden, dass im Ring ungesättigte cycloaliphatische oder heterocycloaliphatische Aroylverbindungen, vor allem Aryl-cycloalkenyl-ketone und Aryl-oxacycloalkenyl-ketone, in ihrer Brauchbarkeit als Photoinitiatoren den aus der EP-A 3002 bekannten gesättigten Verbindungen nicht nachstehen und in Einzelfällen gewisse Vorteile zeigen. Ob diese ungesättigten Ketone sich in die Polymerkette durch Copolymerisation einbauen, ist noch nicht mit Sicherheit bekannt, möglicherweise ist ein solcher Einbau von Vorteil.

Gegenstand der Erfindung ist ein Verfahren zur Photopolymerisation ungesättigter Verbindungen in Gegenwart eines Photoinitiators aus der Reihe der Aroylverbindungen, dadurch gekennzeichnet, dass man als Photoinitiator eine oder mehrere Verbindungen der Formeln I, II, III, IV oder V verwendet,

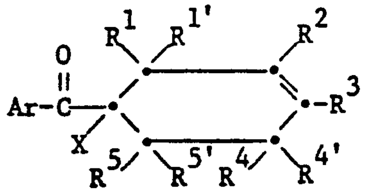 I 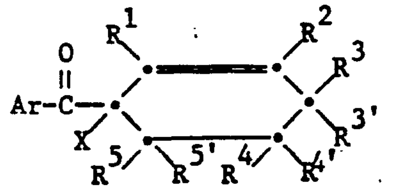 II

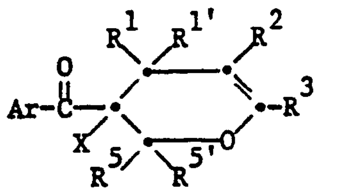 III 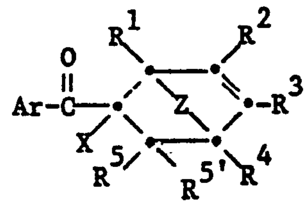 IV

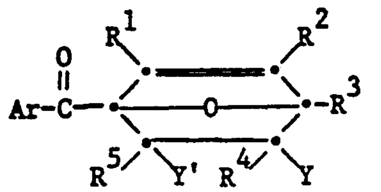 V

worin

Ar unsubstituiertes oder durch einen oder mehrere der Reste Halogen, Phenyl, $C_1$-$C_{12}$-Alkyl, $C_5$-$C_8$-Cycloalkyl, -OH, $C_1$-$C_4$-Alkoxy, Phenoxy, -SH, $C_1$-$C_4$-Alkylthio, Phenylthio, 2-Hydroxyethylthio, $C_2$-$C_5$-Alkanoylamino, Benzoylamino, $C_2$-$C_{12}$-Dialkylamino, Pyrrolidino, Piperidino, Morpholino, 4-Methylpiperazino oder Benzoyl substituiertes $C_6$-$C_{12}$-Aryl, Thienyl, Pyridyl oder Furyl ist,

$R^1$, $R^{1'}$, $R^2$, $R^3$, $R^{3'}$, $R^4$, $R^{4'}$, $R^5$ und $R^{5'}$ unabhängig voneinander H, $C_1$-$C_8$-Alkyl, Phenyl oder $C_3$-$C_8$-Alkenyl sind,

X ein Rest -N($^6$) ($R^7$), -$OR^8$ oder -OSi($R^9$)$_2$($R_{10}$) ist, worin $R^6$ und $R^7$ unabhängig voneinander H, $C_1$-$C_{12}$-Alkyl, durch OH, $C_1$-$C_{12}$-Alkoxy, $C_2$-$C_5$-Carboalkoxy oder CN substituiertes $C_2$-$C_4$-Alkyl, $C_3$-$C_5$-Alkenyl, Cycloalkyl, $C_7$-$C_9$-Phenylalkyl oder Phenyl bedeuten oder $R^6$ und $R^7$ zusammen $C_3$-$C_5$-Alkylen, das durch -O- oder -N($CH_3$)- unterbrochen sein kann, bedeuten, $R^8$ Wasserstoff, $C_1$-$C_{12}$-Alkyl, $C_3$-$C_{12}$-Alkoxyalkyl, $C_3$-$C_5$- Alkenyl, Benzyl, Phenyl oder 2-Tetrahydropyranyl bedeutet und $R^9$ und $R^{10}$ $C_1$-$C_4$-Alkyl oder Phenyl bedeuten,

Y Wasserstoff, -CN, -COOH, -COOR, -CO-R oder -CO-Phenyl ist, wobei $R^{11}$ $C_1$-$C_{12}$-Alkyl, $C_2$-$C_4$-Hydroxyalkyl $C_3$-$C_8$-Alkoxyalkyl oder Cyclohexyl bedeutet und $R^{12}$ Wasserstoff oder $C_1$-$C_4$-Alkyl ist,

Y' Wasserstoff, -COOH oder -$COOR^{11}$ ist oder Y und Y' zusammen -CO-O-CO- sind und

Z eine Gruppe der Formel

$$-CH_2-, \; -CH_2CH_2-, \; -C(CH_3)_2-, \; -\overset{\overset{O}{\|}}{C}- \text{ oder } -O- \text{ ist.}$$

Ar als unsubstituiertes Aryl kann Phenyl, Naphthyl oder Diphenylyl sein. Ar als substituierter Arylrest ist vorzugsweise ein substituierter Phenylrest. Beispiele für Ar als substituierter Arylrest sind: 4-Chlorphenyl, 3-Bromphenyl, 4-Brom-1-naphthyl, 2,4-Dichlorphenyl, p-Tolyl, o-Tolyl, 2,4-Xylyl, 4-tert.Butylphenyl, 4-Isopropylphenyl, 4-Nonylphenyl, 4-Cyclohexylphenyl, 2,4,6-Trimethylphenyl, 2-Ethoxyphenyl, 4-Methoxyphenyl, 4-Butoxyphenyl, 4-Phenoxyphenyl, 3-Methylthiophenyl, 4-(2-Hydroxyethylthio)phenyl, 4-Phenylthiophenyl, 4-Acetylaminophenyl, 3-Benzoylaminophenyl, 3-Dimethylaminophenyl, 4-Diethylaminophenyl, 4-Morpholinophenyl, 4-(4-Methylpiperazino)phenyl oder 3- oder 4-Benzoylphenyl.

$R^1$, $R^{1'}$, $R^2$, $R^3$, $R^{3'}$, $R^4$, $R^{4'}$, $R^5$ und $R^{5'}$ als Alkyl können z.B. Methyl, Ethyl, Isopropyl, Butyl, Hexyl oder Octyl sein. Dieselben Substituenten können als Alkenyl z.B. Allyl, Methallyl oder 2-Butenyl-1 sein. Bevorzugt sind $R^1$ bis $R^5$ Wasserstoff oder Methyl und $R^{1'}$ bis $R^{5'}$ Wasserstoff.

X als Aminorest $-N(R^6)(R^7)$ kann eine primäre, sekundäre oder tertiäre Aminogruppe sein, wie z.B. Methylamino, Butylamino, Dodecylamino, Dimethyl-, Diethyl-, Diisopropyl-, Dibutyl-, Dihexyl- oder Didecylamino, 2-Hydroxyethyl-, Di-(2-hydroxyethyl)-, Di-(2-methoxyethyl)-, 3-Ethoxypropyl-, 2-Butoxypropyl-, 3-Dodecyloxypropyl-, 2-Cyanoethyl-, Di(2-cyanoethyl)-, Allyl-, Diallyl-, Methyl-allyl-, Cyclohexyl-butyl-, Benzyl-, 2-Phenylethyl-, Dibenzyl-, Benzyl-dodecyl-, Benzyl-cyclohexyl-, Phenyl-methyl- oder Phenyl-benzyl-amino, Pyrrolidino, Piperidino, Morpholino oder 4-Methylpiperazino.

X als Rest $-OR^8$ kann Hydroxyl sein oder eine Ethergruppe wie z.B. Methoxy, Ethoxy, Butoxy, 2-Ethylbutoxy, Isodecyloxy, n-Dodecyloxy, 2-Butoxyethoxy, Allyloxy, Methallyloxy, Benzyloxy, Phenoxy oder Tetrahydropyranyl-2-oxy.

X als Rest $-OSi(R^9)_2(R^{10})$ kann z.B. Trimethylsiloxy, Tripropylsiloxy, Triphenylsiloxy, Dimethyl-phenylsiloxy, Methyl-diphenylsiloxy oder Dimethyl-tert-butylsiloxy sein.

Wenn Y oder Y' eine Gruppe $-COOR^{11}$ bedeutet, so kann $R^{11}$ Alkyl sein, wie z.B. Methyl, Ethyl, Isopropyl, tert.-Butyl, n-Butyl, n-Hexyl, 2-Ethylbutyl, n-Octyl, iso-Octyl oder n-Dodecyl.

$R^{11}$ kann auch Hydroxyalkyl oder Alkoxyalkyl sein, wie z.B. 2-Hydroxy-ethyl, 2-Hydroxypropyl, 3-Hydroxybutyl, 2-Methoxyethyl, 2-Butoxyethyl, 2-Ethoxypropyl oder 2-Hexyloxyethyl.

Bevorzugt ist die Verwendung von Photoinitiatoren der Formeln I, II, III, IV oder V, worin Ar unsubstituiertes oder durch Chlor, $C_1$-$C_4$-Alkyl, $C_1$-$C_4$-Alkoxy, $C_1$-$C_4$-Alkylthio, 2-Hydroxyethylthio, Phenoxy, Phenylthio oder Benzoyl substituiertes $C_6$-$C_{10}$-Aryl ist, $R^1$, $R^2$, $R^3$, $R^4$, $R^5$ unabhängig voneinander H, Phenyl oder Methyl und $R^{1'}$, $R^{3'}$, $R^{4'}$ und $R^{5'}$ Wasserstoff sind, X ein Rest $-N(R^6)(R^7)$, $-OR^8$ oder $-OSi(R^9)_3$ ist, worin $R^6$ und $R^7$ unabhängig voneinander H, $C_1$-$C_4$-Alkyl, $C_3$-$C_5$-Alkenyl oder beide Reste zusammen $C_3$-$C_5$-Alkylen, das durch -0- oder $-N(CH_3)$-unterbrochen sein kann, bedeuten, $R^8$ Wasserstoff, $C_1$-$C_{12}$-Alkyl, $C_3$-$C_5$-Alkenyl, Benzyl oder 2-Tetrahydropyranyl bedeutet und $R^9$ Methyl oder Phenyl bedeutet, Y ein Rest -CN oder $-COOR^{11}$ und Y' Wasserstoff oder $-COOR^{11}$ ist, wobei $R^{11}$ $C_1$-$C_4$-Alkyl bedeutet, und Z eine Gruppe der Formel $-CH_2-$, $-CH_2CH_2-$, $-C(CH)_2-$ oder -O- ist.

Besonders bevorzugt ist die Verwendung von Photoinitiatoren der Formeln I, II, oder IV, worin Ar Phenyl oder durch Cl, $CH_3$, $-OCH_3$, $-SCH_3$, Phenoxy oder Benzoyl substituiertes Phenyl ist, $R^1$, $R^2$, $R^3$, $R^4$ und $R^5$ unabhängig voneinander Wasserstoff oder Methyl und $R^{1'}$, $R^{3'}$, $R^{4'}$ und $R^{5'}$ Wasserstoff sind, X ein Rest $-N(R^6)(R^7)$ $-OR^8$ oder $-OSi(R^9)_3$ ist, worin $R^6$ und $R^7$ $C_1$-$C_4$-Alkyl oder $R^6$ und $R^7$ zusammen $C_3$-$C_5$-Alkylen, das durch -O- oder $-N(CH_3)$-unterbrochen sein kann, bedeuten, $R^8$ Wasserstoff, Methyl, Allyl oder Benzyl und $R^9$ Methyl ist, und Z eine Gruppe der Formel -CH -, $-CH_2CH_2$-oder -O- ist.

Beispiele für erfindungsgemäss verwendbare Verbindungen der Formel I sind:

1-Benzoyl-1-diethylamino-cyclohexen-3
1-Benzoyl-1-hydroxy-6-methyl-cyclohexen-3
1-Benzoyl-1-dimethylamino-cyclohexen-3
1-Benzoyl-1-hydroxy-4-methyl-cyclohexen-3
1-Benzoyl-1-hydroxy-3-methyl-cyclohexen-3
1-Benzoyl-3,4-dimethyl-1-hydroxy-cyclohexen-3
1-Benzoyl-1-hydroxy-cyclohexen-3
1-(3,4-Dimethylbenzoyl)-1-hydroxy-2-phenyl-cyclohexen-3
1-(p-Toluyl)-1-morpholino-4-methylcyclohexen-3
1-(4-Phenylthiobenzoyl)-1-cyclohexylamino-cyclohexen-3
1-β-Naphtoyl-1-hydroxy-4-methylcyclohexen-3
1-Furoyl-1-trimethylsiloxy-4-methylcyclohexen-3
1-(4-Propionylamidobenzoyl)-1-phenoxy-4-methylcyclohexen-3
1-(4-Dimethylaminobenzoyl)-1-(dimethyl-tert.butylsiloxy)-3,4-dimethyl-cyclohexen-3
1-(4-Morpholinobenzoyl)-1-benzyloxy-2,5-dimethylcyclohexen-3
1-(4-Benzoylbenzoyl)-1-hydroxy-2,5-diphenylcyclohexen-3
1-(4-Cyclopentylbenzoyl)-1-(diallylamino)-4-methyl-6-ethyl-cyclohexen-3
1-(2,3-Dichlorbenzoyl)-1-hydroxy-4-butylcyclohexen-3
1-(3,4-Bis(methylthio)benzoyl)-1-anilino-cyclohexen-3
1-(3,4-Dibutylbenzoyl)-1-(4-methylpiperazino)-3,4-dimethyl-6-ethyl-cyclohexen-3
1-(4-Butoxybenzoyl)-1-dibenzylamino-cyclohexen-3
1-(3-Diethylaminobenzoyl)-1-(4-methylpiperazino)-2,6-dimethylcyclo-hexen-3
1-(4-Cyclohexylbenzoyl)-1-allyloxy-5-propylcyclohexen-3
1-(3-Chlor-4-propylbenzoyl)-1-morpholino-2,5-diphenyl-6,6-dimethyl-cyclohexen-3
1-([4-(2-Hydroxyethylthio)benzoyl]-6-ethyl-1-hydroxy-3 4 6-trimethyl-cyclohexen-3
1-Benzoyl-6-methyl-1-trimethylsiloxy-cyclohexen-3
1-(4-Isopropylbenzoyl)-1-hydroxy-2,3,4,5,6-pentamethyl-cyclohexen-3

2,6-Dimethyl-1-morpholino-3-phenyl-1-(3-phenoxybenzoyl)-cyclohexen-3
6-Ethyl-1-(3,4-dimethoxybenzoyl)-1-morpholino-3,5, 5-trimethyl-cyclohexen-3
1-[3-(2-Hydroxyethylthio)-4-methoxy-benzoyl]-morpholino-3,4,6-trimethyl-cyclohexen-3
6-Methyl-1-(4-methylthiobenzoyl)-1-morpholino-cyclohexen-3
6-Methyl-1-(4-methoxybenzoyl)-1-morpholino-cyclohexen-3
6-Ethyl-3,4-dimethyl-1-[4-(2-hydroxyethylthio)benzoyl]-l-morpholino cyclohexen-3
2,6-Dimethyl-1-(4-isopropylthiobenzoyl)-1-di(2-methoxyethyl)amino-cyclohexen-3
6,6-Dimethyl-1-(4-methoxybenzoyl)-1-morpholino-cyclohexen-3
1-(4-Hydroxybenzoyl)-4-methyl-1-[N-methyl-N-(2-methoxyethyl)-amino] 6-phenyl-cyclohexen-3
1-(4-Ethoxybenzoyl)-6-ethyl-3-phenyl-1-piperidino-cyclohexen-3
5,6-Dimethyl-1-(4-mercaptobenzoyl)-1-morpholino-cyclohexen-3

Beispiele für Verbindungen der Formel II sind:

1-Benzoyl-hydroxy-cyclohexen-2
1-Hydroxy-3-methyl-1-(4-toluyl)-cyclohexen-2
1-(4-Chlorbenzoyl)-3,5,5-trimethyl-1-trimethylsiloxy-cyclohexen-2
1-Hydroxy-1-(3-pyridylcarbonyl)-cyclohexen-2
3-Methyl-1-(2-tetrahydropyranyl)oxy-1-thenoyl-cyclohexen-2
1-(4-Dodecylbenzoyl)-3-methyl-1-(phenyl-dimethylsiloxy)-cyclohexen-2
1-(4-tert. Butylthiobenzoyl)-1-hydroxy-3,5,5-trimethyl-cyclohexen-2
1-(2,4-Dichlorbenzoyl)-1-dimethylamino-6-isopropyl-cyclohexen-2
1-(4-Methoxybenzoyl)-1-morpholino-cyclohexen-2
4-tert-Butyl-1-(4-methylthiobenzoyl)-1-morpholino-cyclohexen-2

Beispiele für Verbindungen der Formel III sind:

2-Methyl-3-(4-methylthiobenzoyl)-3-morpholino-3,4-dihydro-2H-pyran
2-Ethyl-3-(2,6-dichlorbenzoyl)-3-trimethylsiloxy-3,4-dihydro-2H-pyran
2,6-Dimethyl-3-(4-methoxybenzoyl)-3-morpholino-3,4-dihydro-2H-pyran
3-Hydroxy-3-(4-toluyl)-3,4-dihydro-2H-pyran

Beispiele für Verbindungen der Formel IV sind:

2-Benzoyl-2-morpholino-bicyclo[2.2.1]hepten-5
2-Benzoyl-2-hydroxy-bicyclo[2.2.1]hepten-5
2-(4-Phenoxybenzoyl)-2-butoxy-7,7-dimethyl-bicyclo[2.2.1]hepten-5
1-Methyl-2-(3,4-dichlorbenzoyl)-2-hydroxy-bicyclo[2.2.1]hepten-5
2-(4-Brombenzoyl)-2-pyrrolidino-3-methyl-bicyclo[2.2.1]hepten-5
2-(4-Benzoylbenzoyl)-2-benzyloxy-7,7-dimethyl-bicyclo[2.2.1]hepten-5
2-[4-(2-Hydroxyethylthio)benzoyl]-2-dimethylamino-4,7,7-trimethyl-bicyclo[2.2.1]hepten-5
2-(4-Chlorbenzoyl)-2-piperidino-bicyclo[2.2.2]octen-5
2-(4-Benzamido-3-chlorbenzoyl)-2-hydroxy[2.2.2]octen-5
2-(3,4-Diethylbenzoyl)-2-(2-tetrahydropyranyloxy)-3-methyl-bicyclo-[2.2.2]octen-5
2-Benzoyl-2-triphenylsiloxy-7-oxabicyclo[(2.2.1]hepten-5
2-(4-(4-Methylpiperazino)benzoyl)-2-hydroxy-7-oxabicyclo[2.2.1]-hepten-5
2-(4-Ethylthio-3-methylbenzoyl)-2-dimethylamino-3-methyl-7-oxabicyclo-[2.2.1]hepten-5
2-(3-Isopropylbenzoyl)-2-hydroxy-3-phenyl-7-oxabicycloZ[2.2.1]hepten-5
2-(4-Methylthiobenzoyl)-3-methyl-2-morpholino-bicyclo[2.2.1]hepten-5
2-(4-Methoxybenzoyl)-3-methyl-2-morpholino-bicyclo[2.2.1]hepten-5
3-Ethyl-2-(4-(2-hydroxyethylthio)benzoyl)-2-(4-methylpiperazino)-bicyclo[2.2.1]hepten-5
exo-2-Benzoyl-2-hydroxy-bicyclo[2.2.2]octen-5
endo-2-Benzoyl-2-hydroxy-bicyclo[2.2.2]octen-5
2-([-Methoxybenzoyl)-2-morpholino-3-methyl-bicyclo[2.2.2]octen-5
3-Ethyl-2-([-methylthiobenzoyl)-2-morpholino-bicyclo[2.2.2]octen-5
2-[[-(2-Hydroxethylthio)benzoyl]-3-phenyl-2-piperidino -bicyclo[2.2.2]octen-5
2-(4-Methoxybenzoyl)-3-methyl-2-morpholino-7-oxabicyclo[2.2.1]hepten-5
3,3-Dimethyl-2-([-methylthiobenzoyl)-2-morpholino-7-oxabicyclo[2.2.1] hepten-5
2-(4-Chlorbenzoyl)-2-hydroxy-3-methyl-1,4,5,6-tetraphenyl-7-oxa-bicyclo [2.2.1]hepten-5

Beispiele für Verbindungen der Formel V sind:

1-Benzoyl-5-ethoxycarbonyl-7-oxabicyclo[2.2.1]hepten-2
1-(3,4-Dimethylbenzoyl)-5-(2-ethylhexyloxycarbonyl)-7-oxabicyclo-[2.2.1]hepten-2
1-(4-Ethoxybenzoyl)-5-methoxycarbonyl-6-methyl-7-oxabicycl o[2.2.1]-hepten-2
1-[4-(2-Hydroxyethylthio)-benzoyl]-5-cyano-7-oxabicyclo[2.2.1]hepten-2
1-α-Naphthoyl-5-carboxy-7-oxabicyclo[2.2.1]hepten-2
1-(3,4-Dichlorbenzoyl)-4-methyl-5-benzoyl-7-oxabicyclo[2.2.1]hepten-2
1-(4-Benzoylbenzoyl)-5-formyl-7-oxabicyclo[2.2.1]hepten-2
1-(4-Dodecylbenzoyl)-5-methyl-5-formyl-7-oxabicyclo[2.2.1]hepten-2
1-Benzoyl-5,6-bis(ethoxycarbonyl)-7-oxabicyclo[2.2.1]hepten-2
1-([-Phenylbenzoyl)-5-methoxycarbonyl-6-carboxy-7-oxabicyclo(2.2.1]-hepten-2
1-(4-Phenylbenzoyl)-5-carboxy-6-methoxycarbonyl-7-oxabicyclo[2.2.1]-hepten-2

1-Benzoyl-6-ethoxycarbonyl-2,3-dimethyl-7-oxabicyclo(2.2.1]hepten-2
1-Benzoyl-7-oxabicyclo[2.2.1]hept-2-en-5,6-dicarbonsäure-5,6-anhydrid

Von den erfindungsgemäss verwendbaren Verbindungen ist die Verbindung der Formel I, worin Ar Phenyl ist, X Hydroxyl ist, $R^3$ Methyl ist und $R^1$, $R^{1'}$, $R^2$, $R^4$, $R^{4'}$, $R^5$ und $R^{5'}$ Wasserstoff sind, eine bekannte Verbindung. Sie lässt sich gemäss T. Sasaki, Y. Ishibashi und M. Ohno / Tetrahedron Letters 23, 1693 (1982) durch eine Diels-Alder-Reaktion in folgender Weise herstellen:

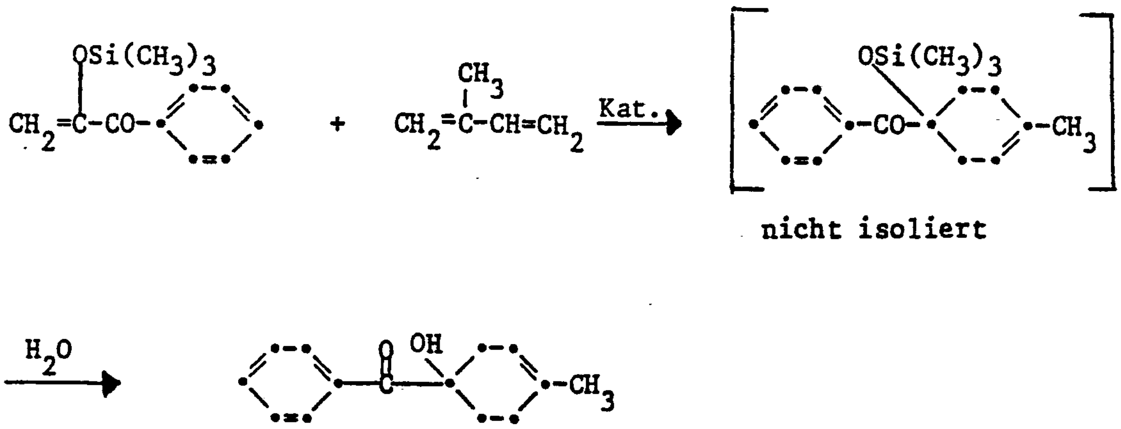


$SnCl_4$ und $BF_4.(C_2H_5)_3O$ wurden als Katalysator für die Cycloaddition verwendet. Das primäre Cyclisierungsprodukt wurde ohne Isolation mit methanolischer Salzsäure hydrolysiert.

Alle anderen erfindungsgemäss verwendbaren Verbindungen der Formeln I, II, III, IV und V sind neue Verbindungen und sind als solche ebenfalls Gegenstand der Erfindung.

Sie können nach verschiedenen Methoden hergestellt werden.

Eine für die Herstellung von Verbindungen der Formel I, III und IV allgemein verwendbare Methode ist die Diels-Alder-Reaktion. Hierbei wird ein α-substituiertes Aryl-vinyl-keton VI als Dienophil mit einem Dien VII zur Reaktion gebracht. Verwendet man als Dien ein offenkettiges Dien, so entstehen dabei Verbindungen der Formel I:

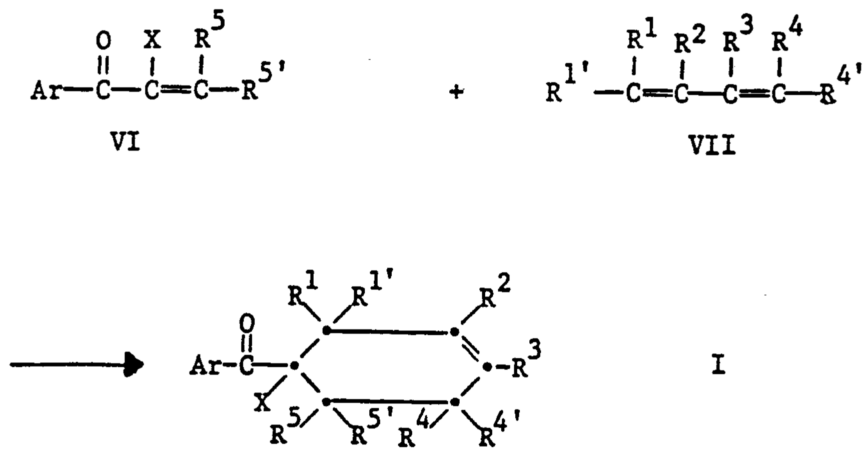

VI VII

I

Die vorhin geschilderte Synthese von 1-Benzoyl-1-hydroxy-4-methyl-cyclohexen-3 gemäss Sasaki et al. ist ein spezieller Fall dieser allgemeinen Herstellungsmethode. Beispiele für Diene der Formel VII sind die für Diels-Alder-Reaktionen allgemein geeigneten Diene, wie z.B Butadien, Isopren, 2,3-Dimethylbutadien oder 1,4-Diphenylbutadien.

Verwendet man als Dien eine α, β-ungesättigte Carbonylverbindung (VIII), so erhält man ein Produkt der Formel III:

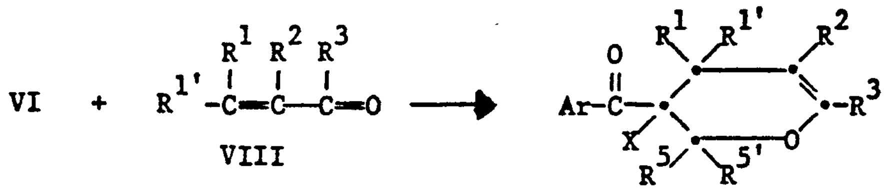

VI + VIII

III

Beispiele für VIII sind vor allem Acrolein, Methacrolein und Methylvinylketon.

Verwendet man als Dien ein cyclisches Dien (IX), so erhält man ein Produkt der Formel IV:

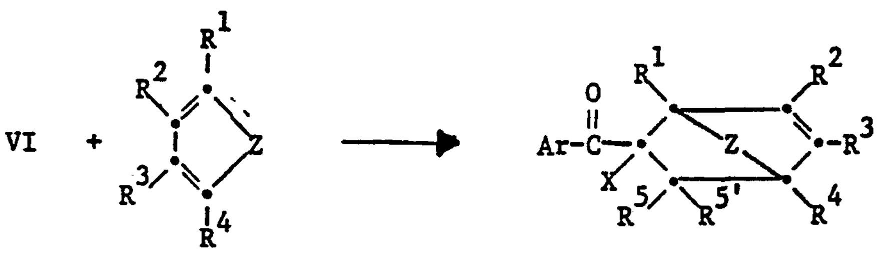

VI IX IV

Beispiele für cyclische Diene IX sind vor allem Cyclopentadien, Cyclohexadien und Furan.

In allen diesen Fällen der Diels-Alder-Reaktion kann die Gruppe X im cyclischen Addukt erhalten werden oder man transformiert die Gruppe X in einer anschliessenden Reaktionsstufe in eine davon verschiedene Gruppe X. Ein Beispiel ist die vorhin aufgeführte Synthese von 1-Benzoyl-1-hydroxy-4-methyl-cyclohexen-3 gemäss Sasaki et al., in der als X zunächst die Gruppe $-OSi(CH_3)_3$ eingeführt wird, die durch anschliessende Hydrolyse in eine OH-Gruppe transformiert wird.

Die Diels-Alder-Reaktion kann durch Lewis-Säuren katalysiert werden. Beispiele hierfür sind $AlCl_3$, $C_2H_5AlCl_2$, $(C_2H_5)_2AlCl$, $SnCl_4$, $BF_3$ und $BF_3$-Addukte.

Eine Variante dieser Diels-Alder-Reaktionen kann zur Herstellung von Verbindungen der Formel V verwendet werden. Man verwendet hierfür 2-Aroylfurane (X) als Dien und α, β-ungesättigte Carbonsäuren oder deren Derivate (XI) als Dienophil:

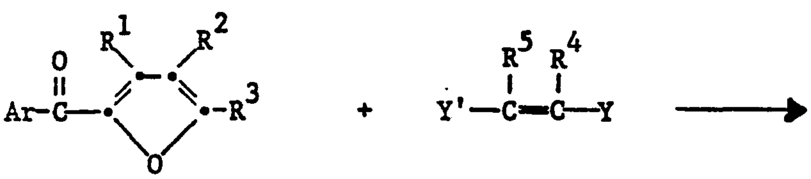

X XI

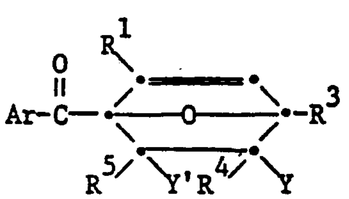

V

Beispiele von geeigneten Dienophilen der Formel XI sind Acrylsäure und Methacrylsäure und deren Ester und Nitrile, Maleinsäure und deren Anhydrid, Ester und Halbester sowie Vinylketone. Verwendet man als Dienophil Maleinsäureanhydrid, so kann man das Addukt durch Hydrolyse oder Veresterung entsprechend umwandeln.

Eine Methode, die allgemein zur Herstellung von Verbindungen der Formeln I, II, III und IV verwendbar ist, ist die Umsetzung der entsprechenden 1-Cyanoverbindungen mit aromatischen Grignard-Verbindungen. Die 1-Cyanoverbindungen sind Cyanhydrine oder α-Aminonitrile und demzufolge aus den entsprechenden 1-Oxoverbindungen erhältlich. Dies sei am Beispiel der Synthese von II schematisch dargestellt:

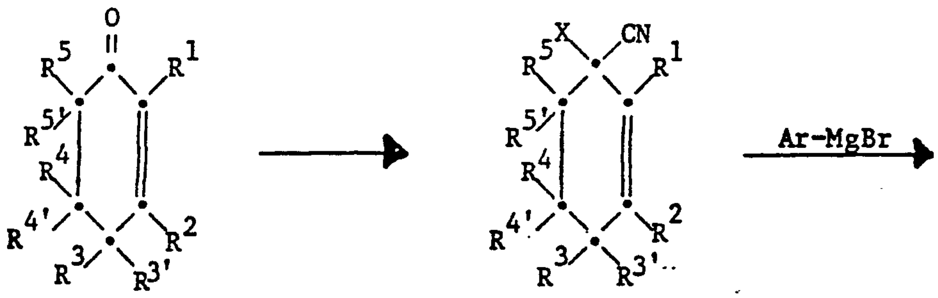


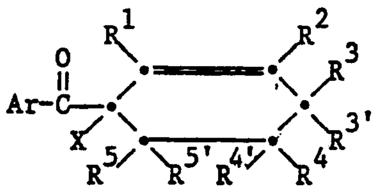

II

Anstelle der freien Cyanhydrine (X = OH) können zur Grignard-Synthese vorteilhaft Derivate verwendet werden, in denen die OH-Gruppe durch Schutzgruppen blockiert ist, die nach der Grignard-Reaktion hydrolytisch abspaltbar sind. Beispiele hierfür sind die Trimethylsilyl-Derivate oder die Tetrahydropyran-Addukte. Solche blockierte Cyanhydrine können aus den Oxoverbindungen auch in einem Schritt hergestellt werden, z.B. durch Umsetzung mit Trimethylsilylcyanid nach der Methode von S. König et al., Chem. Ber. 113, 3783 (1980).

Nähere Details der Herstellungsmethoden können den später folgenden Beispielen entnommen werden.

Die Verbindungen der Formeln I, II, III, IV und V eignen sich als Photoinitiatoren zur Photopolymerisation ungesättigter Verbindungen. Hierbei handelt es sich um einfach oder mehrfach olefinisch ungesättigte Verbindungen und deren Gemische. Die ungesättigten Verbindungen können niedermolekular (monomer) oder höhermolekular (oligomer) sein.

Beispiele für Monomere mit einer Doppelbindung sind Alkyl- oder Hydroxyalkyl-acrylate oder -methacrylate, wie z.B. Methyl-, Ethyl-, Butyl-, 2-Ethylhexyl- oder 2-Hydroxyethylacrylat, Isobornylacrylat, Methyl- oder Ethylmethacrylat. Weitere Beispiele hierfür sind Acrylnitril, Acrylamid, Methacrylamid, N-substituierte (Meth)acrylamide, Vinylester wie Vinylacetat, Vinylether wie Isobutylvinylether, Styrol, Alkyl- und Halogenstyrole, N-Vinylpyrrolidon, Vinylchlorid oder Vinylidenchlorid.

Beispiele für Monomere mit mehreren Doppelbindungen sind Ethylenglykol-, Propylenglykol-, Neopentylglykol-, Hexamethylenglykol-, oder Bisphenol-A diacrylat, [,[′-Bis(2-acryloyloxyethoxy)-diphenylpropan, Trimethylolpropan-triacrylat, Pentaerythrit-triacrylat oder -tetraacrylat, Vinylacrylat, Divinylbenzol, Divinylsuccinat, Diallylphthalat, Triallylphosphat, Triallylisocyanat oder Tris(2-acryloyl-oxyethyl)isocyanurat.

Beispiele für höhermolekulare (oligomere) mehrfach ungesättigte Verbindungen sind acrylierte Epoxidharze, acrylierte Polyether, acrylierte Polyurethane oder acrylierte Polyester. Weitere Beispiele für ungesättigte Oligomere sind ungesättigte Polyesterharze, die meist aus Maleinsäure, Phthalsäure und einem oder mehreren Diolen hergestellt werden und Molekulargewichte von etwa 500 bis 3000 besitzen. Solche ungesättigte Oligomere kann man auch als Prepolymere bezeichnen.

Als photopolymerisierbare Gemische können z.B. Gemische eines einfach ungesättigten mit einem mehrfach ungesättigten Monomeren sein. Häufiger verwendet man jedoch Gemische eines mehrfach ungesättigten

Monomeren mit einem ungesättigten Oligomer (Prepolymer). Auch Dreikomponenten-Gemische dieser Art werden häufig verwendet. Das Prepolymere ist hierbei in erster Linie für die Eigenschaften des Polymerisates massgebend, durch seine Variation kann der Fachmann die Eigenschaften des gehärteten Filmes beeinflussen. Das mehrfach ungesättigte Monomere fungiert als Vernetzer, das das Polymer unlöslich macht. Das einfach ungesättigte Monomere fungiert als reaktiver Verdünner, mit dessen Hilfe die Viskosität herabgesetztwird ohne dass man ein Lösungsmittel verwenden muss.

Solche Zwei- und Dreikomponentensysteme auf der Basis eines Prepolymeren werden sowohl für Druckfarben als auch für Lacke, Photoresists oder andere gefärbte photohärtbare Massen verwendet. Als Bindemittel für Druckfarben werden vielfach auch Einkomponenten-Systeme auf der Basis photohärtbarer Prepolymerer verwendet.

Ungesättigte Polyesterharze werden meist in Zweikomponentensystemen zusammen mit einem einfach ungesättigten Monomer, vorzugsweise mit Styrol, verwendet. Für Photoresists werden oft spezifische Einkomponentensystemeverwendet, wie z.B. Polymaleinimide oder Polyalkone.

Das photopolymerisierbare Gemisch kann ausserdem kleinere Anteile an nicht-photopolymerisierbaren filmbildenden Komponenten enthalten. Diese können z.B. physikalisch trocknende Polymere bzw. deren Lösungen in organischen Lösungsmitteln sein, wie z.B. Nitrocellulose oder Celluloseacetobutyrat. Diese können aber auch chemisch bzw. thermisch härtbare Harze sein, wie z.B. Polyisocyanate, Polyepoxide oder Melaminharze. Die Mitverwendung von thermisch härtbaren Harzen ist für die Verwendung in sogenannten Hybrid-Systemen von Bedeutung, die in einer ersten Stufe photopolymerisiert werden und in einer zweiten Stufe durch thermische Nachbehandlung vernetzt werden.

Die photopolymerisierbaren Gemische können - je nach ihrem Verwendungszweck - eine Reihe sonstiger Zusätze enthalten. Beispiele hierfür sind thermische Inhibitoren, die eine Polymerisation vor der Bestrahlung verhindern und damit die Lagerstabilität erhöhen sollen. Beispiele hierfür sind Hydrochinon und Hydrochinon-Derivate, Naphthole, Kupferverbindungen, organische Phosphorverbindungen, quartäre Ammoniumverbindungen oder Hydroxylaminderivate.

Andere bekannte Zusatzstoffe sind Härtungsbeschleuniger, wie z.B. tertiäre Amine Aminocarbonsäureester und Aminoketone. Beispiele hierfür sind Triethanolamin, N-Methyldiethanolamin, p-Dimethylaminobenzoesäurealkylester oder Michler Keton. Auch die Kombination mit einem anderen Photoinitiator vom Arylketontyp, wie z.B. mit Benzophenonderivaten, Anthrachinonderivaten, Thioxanthonderivaten, Benzilketalen, α-Hydroxyacetophenonderivaten oder Benzoinderivaten kann eine beschleunigende Wirkung auf die Photopolymerisation ausüben.

Um die inhibierende Wirkung des Luftsauerstoffs auszuschliessen, setzt man photohärtbaren Gemischen häufig Paraffin oder ähnliche wachsartige Stoffe zu. Diese schwimmen bei Beginn der Polymerisation wegen mangelnder Löslichkeit im Polymeren aus und bilden eine transparente Oberflächenschicht, die den Zutritt von Luft verhindert. Auch durch Einführung von autoxydablen Gruppen, beispielsweise Allylgruppen, in das zu härtende Harz kann der Luftsauerstoff desaktiviert werden.

Weitere häufig verwendete Zusätze sind Füllstoffe wie Kieselsäure, Talkum oder Gips, Pigmente, Farbstoffe, Fasern, Thixotropiemittel oder Verlaufhilfsmittel.

Die wichtigsten Anwendungsgebiete der Photopolymerisation sind die der Lacke und Druckfarben, der Herstellung von Photoresists und der Herstellung von Druckplatten. Die erfindungsgemässen Photoinitiatoren werden den photopolymerisierbaren Verbindungen in einer Menge von 0,1 bis 20 Gew.-%, insbesondere 0,5 bis 5 Gew.-%, zugesetzt.

Der Zusatz der Photoinitiatoren zu den photopolymerisierbaren Gemischen geschieht im allgemeinen durch einfaches Einrühren, da die meisten dieser Gemischeflüssig oder gut löslich sind. Meist kommt es zu einer Lösung der erfindungsgemässen Initiatoren, wodurch deren gleichmässige Verteilung sowie die Transparenz der Polymerisate gewährleistet ist.

In bestimmten Fällen kann es von Vorteil sein, zwei oder mehrere Verbindungen der Formeln I, II, III, IV oder V dem photopolymerisierbaren Gemisch zuzusetzen.

Die Polymerisation erfolgt nach den bekannten Methoden der Photopolymerisation durch Bestrahlung mit Licht, das reich an kurzwelliger Strahlung ist. Als Lichtquellen sind z.B. Quecksilbermitteldruck-, -hochdruck- und -niederdruckstrahler, sowie superaktinische Leuchtstoffröhren geeignet, deren Emissionsmaxima im Bereich zwischen 250 und 400 mm liegen.

Durch Zusatz von Photosensibilisatoren kann man die spektrale Empfindlichkeit in bestimmte Bereiche verschieben, sodass man auch mit relativ langwelligen Lampen arbeiten kann. Beispiele für solche Photosensibilisatoren sind organische Farbstoffe oder mehrkernige kondensierte aromatische Verbindungen wie z.B. Perylen, Anthracen-Derivate oder Thioxanthon-Derivate.

Die folgenden Beispiele erläutern die Herstellung der erfindungsgemässen Verbindungen und ihre Anwendung als Photoinitiatoren. Teile bedeuten darin Gewichtsteile, die Temperaturen sind in °C angegeben.

**Beispiel 1**

Herstellung von 1-Benzoyl-1-hydroxycyclohexen-3 durch Diels-Alder-Synthese

a) Nach der Methode von W.H. Hartung und F. Crossley (Organic Synthesis Coll. Vol. II, 363) werden 315 g

(2,35 Mol)Propiophenon mit Methylnitrit (in situ erzeugt aus 186 g $NaNO_2$ und 121,5 ml Methanol in Gegenwart von 150 ml $H_2SO_4$ konz.) umgesetzt. Nach Aufarbeitung und Umkristallisation aus Toluol werden 165 g 1-Phenylpropan-1,2-dion-2-oxim vom Smp. 115° erhalten.

b) 100 g dieses Oxims werden nach der Methode von W.W. Hartman und L.J. Roll (Organic Synthesis Coll. Vol. III, 20) durch Wasserdampfdestillation aus 20%iger Schwefelsäure in 1-Phenylpropan-1,2-dion überführt. Ausbeute 87,4 g, gelbes Oel.

c) In einer vorgetrockneten Glasapparatur werden unter einer Stickstoffatmosphäre 0,46 g (3,4 mmol) wasserfreies Zinkchlorid zu 14,8 g (146 mmol) trockenem Triethylamin gegeben. Nach 3-stündigem Rühren bei Raumtemperatur hat sich eine milchige Suspension des Zinkchlorides gebildet, zu der 19,85 g (134 mmol) 1-Phenyl-propan-1,2-dion in 50 ml Methylenchlorid zugegeben werden. Die entstehende homogene Lösung wird im Eisbad gekühlt und langsam mit 15,89 g (146 mmol) Trimethylchlorsilan versetzt. Danach wird das Eisbad entfernt und während 16 Std. bei Raumtemperatur gerührt. Anschliessend wird mit 200 ml trockenem Diethylether verdünnt, 15 Min. gerührt und die ausgefallenen Salze unter Stickstoff über Hyflo abfiltriert. Nach Einengen der Lösung und Trocknen im Hochvakuum werden 29,30 g (99 %) eines braunroten Oels erhalten, das gemäss "H-NMR > 97% 1-Phenyl-2-trimethylsilyloxy-prop-2-en-1-on enthält. Dieses Oel wird ohne weitere Reinigung für die weiteren Umsetzungen eingesetzt.

d) In einer vorgetrockneten Apparatur werden unter einer Argonatmosphäre 7 g (31,7 mmol) 1-Phenyl-2-trimethylsilyloxy-prop-2-en-1-on in 100 ml trockenem Methylenchlorid gelöst und im Eisbad auf 0°C gekühlt. Danach werden 14 ml (~160 mmol) Butadien in die Lösung hineinkondensiert und 4 ml (31,7 mmol) Bortrifluorid-etherat langsam zugegeben. Anschliessend wird etwa 2 Stunden bei 0°C und 14 Std. bei Raumtemperatur unter Argonatmosphäre gerührt. Das Lösungsmittel und das überschüssige Butadien werden am Rotationsverdampfer abdestilliert, der Rückstand in 250 ml Methanol und 25 ml 1N Salzsäure aufgenommen und 30 Min. bei Raumtemperatur gerührt. Anschliessend wird auf 100 ml eiskalte gesättigte Natriumhydrogencarbonat-Lösung gegossen, das Methanol am Rotationsverdampfer abgezogen und die zurückbleibende Wasserphase mit Diethylether extrahiert. Die Extrakte werden über $MgSO_4$ getrocknet, eingeengt und das zurückbleibende viskose braune Oel durch Chromatographie an Kieselgel (Elutionsmittel: Hexan/Essigester 9:1) gereinigt.Es werden 3,50 g (55%) l-Benzoyl-l-hydroxy-cyclohexen-3 erhalten, das durch Kugelrohrdestillation (140-145° / $6.10^{-2}$ Torr)gereinigt wird. Es stellt ein farbloses Oel dar. Analyse $C_{13}H_{14}O_2$ (202,23)

Berechnet: C 77,20 % H 6,98 % O 15,82 %
Gefunden: C 77,11 % H 6,89 % O 15,92 %

Setzt man das 1-Phenyl-2-trimethylsilyloxyprop-2-en-1-on mit Isopren anstelle von Butadien um, so erhält man bei analoger Arbeitsweise ein öliges Produkt, das nach Kugelrohrdestillation (150°/0,06 Torr)folgende Analyse ergab:

$C_{14}H_{16}O_2$ Ber. C 77,75 % H 7,46 % O 14,80 %
(216,28) Gef. C 77,88 % H 7,62 % O 14,81 %

Gemäss 1H-NMR-Analyse (bei 250 MHz) handelt es sich um ein Gemisch von etwa 75 % 1-Benzoyl-1-hydroxy-4-methylcyclohexen-3 und ca. 25 % 1-Benzoyl-1-hydroxy-3-methylcyclohexen-3.

Bei analoger Diels-Alder Reaktion mit 2,3-Dimethylbutadien erhält man das 1-Benzoyl-1-hydroxy-3,4-dimethylcyclohexen-3, das nach Kugelrohrdestillation (140 - 150°/0.07 Torr)ein farbloses Oel darstellt.

Analyse $C_{15}H_{18}O_2$ (230,31)
Ber. C 78,23 % H 7,88 % O 13,90 %
Gef. C 78,26 % H 7,98 % O 13,85 %

**Beispiel 2**

Herstellung von exo/endo-2-Benzoyl-2-hydroxy-bicyclo [2.2.2]oct-5-en durch Diels-Alder-Reaktion

In einer vorgetrockneten Apparatur werden unter einer Argonatmosphäre 8 g (36 mmol) 1-Phenyl-2-trimethylsilyloxy-prop-2-en-1-on in 40 ml trockenem Methylenchlorid gelöst und mit 10 ml (100 mmol) frisch destilliertem 1,3-Cyclohexadien versetzt. Die Lösung wird im Eisbad auf 0°C gekühlt und danach werden 4,6 ml (36 mmol) Bortrifluorid-etherat zugegeben. Anschliessend wird das Reaktionsgemisch zunächst bei 0°C, danach 4 Std. bei Raumtemperatur gerührt. Das Lösungsmittel wird zusammen mit überschussigem Cyclohexadien im Rotationsverdampfer abdestilliert, der verbleibende Rückstand mit 250 ml Methanol und 25 ml 1N Salzsäure aufgenommen und 30 Min. bei Raumtemperatur gerührt. Anschliessend wird auf 100 ml eiskalte Bicarbonat-Lösung gegossen, 15 Min. gerührt und die Lösung am Rotationsverdampfer eingeengt. Die zurückbleibende Wasserphase wird mit Diethylether extrahiert, die Extrakte über $MgSO_4$ getrocknet und das Lösungsmittel abdestilliert. Das zurückbleibende Oel wird durch Flash-Chromatographie an Kieselgel (Elutionsmittel Hexan / Essigester 9:1) gereinigt. Die Hauptfraktion wird durch Kugelrohrdestillation (150°C/0,07 Torr) gereinigt, wobei man 5,37 g (65%) eines farblosen Oels erhält, das gemäss $^1$H-NMR Analyse aus ca. 52 % endo-,24 % exo-2-Benzoyl-2-hydroxy -bicyclo[2.2.2]octen-5")und 24 % 2-Hydroxy-2-phenyl-bicyc1o[3.2.2]non-6-en-3-on besteht. Durch mehrmalige Flash-Chromatographie an Kieselgel (Elutionsmittel: Pentan/ Essigester 9:1) gelingtes die Bestandteile zu trennen:

endo-2-Benzoyl-2-hydroxy-bicyclo[2.2.2]-octen-5, Smp. 69°C (Umkrist. aus Diethylether/Pentan)

Analyse $C_{15}H_{16}O_2$ (228,27)
Berechnet: C 78,92 % H 7,07 % O 14,02 %
Gefunden: C 78,75 % H 7,00 % O 14,02 %
exo-2-Benzoyl-2-hydroxy-bicylo[2.2.2]octen-5, SmP. 47-50° C.
Analyse $C_{15}H_{16}O_2$ (228,27)
Berechnet: C 78,92 % H 7,07 % O 14,02 %
Gefunden: C 78,93 % H 7,01 % O 13,89 %

**Beispiel 3**

Herstellung von l-Benzoyl-1-hydroxy-cyclohexen-2 durch Grignard-Synthese

a)

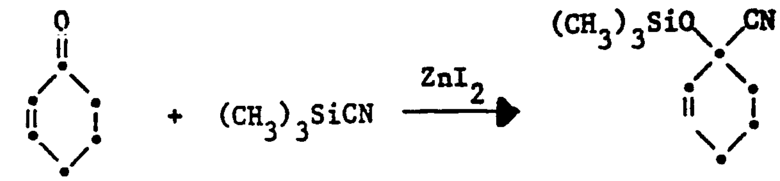


Zu 0,11 Mol Trimethylsilylcyanid und einer Spatelspitze wasserfreiem Zinkiodid werden bei Raumtemperatur und unter Inertgas ($N_2$) 0,1 Mol 2-Cyclohexenon-1 zugetropft. Die Temperatur steigt dabei auf 60° bis 70°. Dann wird noch 3 Stunden auf 100° erwärmt und anschliessend destilliert. Sdp. = 70-72°/1 Torr. Ausbeute = 90%.
*)Das Prefix exo- bezw. endo- bezieht sich auf die sterische Stellung des Benzoylrestes.
Das NMR-Spektrum ist mit der angegebenen Struktur im Einklang.

b)

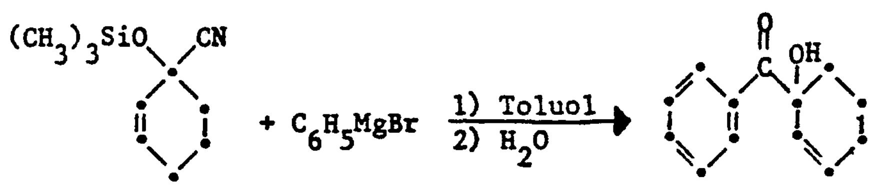


Aus äquimolaren Mengen Brombenzol und Magnesiumspänen werden in 60 ml Diethylether 0,1 Mol Phenylmagnesiumbromid hergestellt. Nach beendeter Reaktion wird mit 100 ml trockenem Toluol verdünnt und der Ether bei 70° unter reduziertem Druck entfernt. Bei 5° wird anschliessend eine Lösung von 0,09 Mol 1-Cyano-1-trimethylsilyloxy-cyclohexen-2 in 20 ml Toluol zugetropft. Man lässt 4-5 Stunden bei Raumtemperatur reagieren, tropft dann unter Kühlung 100 ml einer 25%-igen wässrigen Lösung von Essigsäure zu und rührt noch kurz bei Raumtemperatur. Nach Zugabe von 100 ml Diethylether wird die organische Phase mit Wasser und anschliessend mit Natriumcarbonat-Lösung gewaschen, über $Na_2SO_4$ getrocknet und vom Lösungsmittel befreit.

Zur Hydrolyse des Silylethers wird der erhaltene Rückstand über Nacht mit 3 N HCl in Methanol gerührt. Nach Verdünnen mit Wasser wird dreimal mit Diethylether extrahiert, die vereinigten Extrakte mit Natriumbicarbonat-Lösung geschüttelt, über $Na_2SO_4$ getrocknet und am Rotationsverdampfer eingedampft. Das zurückbleibende Rohprodukt ist ein gelbes Oel.

Zur Reinigung wird das Rohprodukt über einer Kieselgel-Säule chromatographiert. Als Lösungsmittel wird Hexan mit 10% Ethylacetat verwendet. Man erhält das reine 1-Benzoyl-1-hydroxy-cyclohexen-2 als farbloses

Oel in 40-50% Ausbeute. Das NMR-Spektrum stimmt mit der angegebenen Struktur überein.
Elementaranalyse ($C_{13}H_{14}O_2$)
Berechnet 77,20 % C 6.98 % H
Gefunden 77,13 % C 7,02 % H

**Beispiel 4**

Photopolymerisation eines Lackharzes

Eine Harzmischung aus 50 Teilen Actylan AJ 20 (Acrylatharz der Firma UCB, Belgien), 15 Teilen Trimethylolpropan-tris-acrylat, 15 Teilen Dicyclopentadienyloxyethylacrylat, 10 Teilen Hexandioldiacrylat, 10 Teilen N-Vinylpyrrolidon und 2 Teilen Photoinitiator wird mit einem Filmziehgerät in einer Dicke von 40µm auf Glasplatten aufgezogen. Diese Filme werden ca. 20 Sekunden abgelüftet und anschliessend mit einem Hg-Mitteldruckbrenner (Hanovia-Gerät, Modell 45080) bestrahlt. Dabei werden die Proben auf einem Transportband mit einer Geschwindigkeit von 20 m/min unter der UV-Lampe vorbeibewegt.

In der folgenden Tabelle sind in der ersten Spalte die Anzahl Durchläufe (D) angeführt, die notwendig waren, um klebfreie Filme zu er

In der zweiten Spalte wird die Härte der Filme nach verschiedener-Anzahl von Durchläufen, gemessen mit dem Pendelgerät nach König (DIN 53 157), angegeben.

Die letzte Spalte zeigt den Yellowness-Index (YI) des gehärteten Filmes als Kriterium der Vergilbung.

| Photoinitiator | D | Pendelhärte | YI |
|---|---|---|---|
| 1-Benzoyl-1-hydroxycyclohexen-2 | 7 | 95" (7D)<br>110" (9D) | 6 |
| 1-Benzoyl-1-hydroxycyclohexen-3 | 7 | 108" (7D)<br>114" (9D) | 7 |
| 1-Benzoyl-3,4-dimethyl-1-hydroxycyclohexen-3 | 8 | 122" (8D)<br>124" (10D) | 6 |
| Gemisch aus ca. 75% 1-Benzoyl-1-hydroxy-4-methylcyclohexen-3 und 25% 1-Benzoyl-1-hydroxy-3-methylcyclohexen-3 | 9 | 116" (9D)<br>119" (11D) | 6 |
| endo-2-Benzoyl-2-hydroxy-bicyclo [2.2.2]octen-5 | 7 | 136" (7D)<br>149" (9D) | 6 |
| Gemisch ca. 70% endo- und 30%-exo-2-Benzoyl-2-hydroxy-bicyclo [2.2.2]octen-5 | 9 | 109" (9D)<br>137" (11D) | 7 |

**Patentansprüche**

1. Verfahren zur Photopolymerisation ungesättigter Verbindungen in Gegenwart eines Photoinitiators aus der Reihe der Aroylverbindungen, dadurch gekennzeichnet, dass man als Photoinitiator eine oder mehrere Verbindungen der Formeln I II, III, IV oder V verwendet,

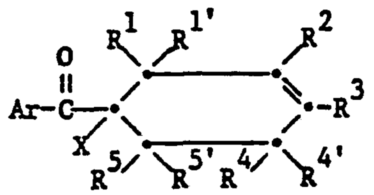 I

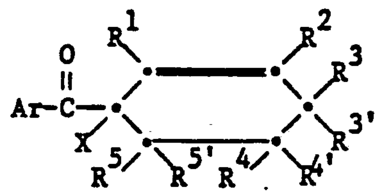 II

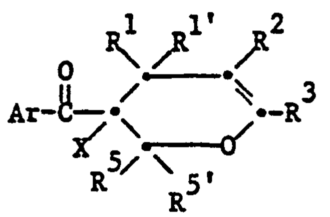 III

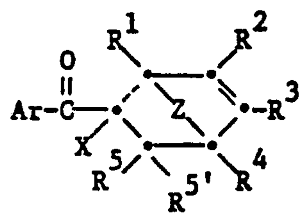 IV

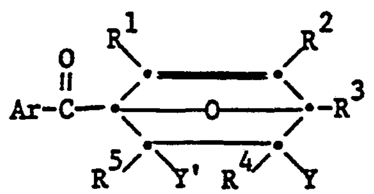 V

worin

Ar unsubstituiertes oder durch einen oder mehrere der Reste Halogen, Phenyl, $C_1$-$C_{12}$-Alkyl, $C_5$-$C_8$-Cycloalkyl, -OH, $C_1$-$C_4$-Alkoxy, Phenoxy, -SH, $C_1$-$C_4$-Alkylthio, Phenylthio, 2-Hydroxyethylthio, $C_2$-$C_5$-Alkanoylamino, Benzoylamino, $C_2$-$C_{12}$-Dialkylamino, Pyrrolidino, Piperidino, Morpholino, 4-Methylpiperazino oder Benzoyl substituiertes $C_6$-$C_{12}$-Aryl, Thienyl, Pyridyl oder Furyl ist,

$R^1$, $R^{1'}$, $R^2$, $R^3$, $R^4$, $R^{4'}$und $R^5$ unabhängig voneinander H, $C_1$-$C_8$-Alkyl, Phenyl oder $C_3$-$C_8$-Alkenyl sind,

X ein Rest -N($R^6$) ($R^7$), -$OR^8$ oder -OSi($R^9$)$_2$($R^{10}$) ist,worin $R^6$ und $R^7$ unabhängig voneinander H, $C_1$-$C_{12}$-Alkyl, durch OH, $C_1$-$C_{12}$-Alkoxy, $C_2$-$C_5$-Carboalkoxy oder CN substituiertes $C_2$-$C_4$-Alkyl, $C_3$-$C_5$-Alkenyl, Cycloakyl, $C_7$-$C_9$-Phenylalkyl oder Phenyl bedeuten oder $R^6$ und $R^7$ zusammen $C_3$-$C_5$-Alkylen, das durch -O- oder -N($CH_3$)- unterbrochen sein kann, bedeuten, $R^8$ Wasserstoff, $C_1$-$C_{124}$-Alkyl, $C_3$-$C_{12}$-Alkoxyalkyl, $C_3$-$C_5$- Alkenyl, Benzyl, Phenyl oder 2-Tetrahydro-pyranyl bedeutet und $R^9$ und $R^{10}$ $C_1$-$C_4$-Alkyl oder Phenyl bedeuten,

Y Wasserstoff, -CN, -COOH, -$COOR^{11}$, -CO-$R^{12}$ oder -CO-Phenyl ist, wobei $R^{11}$ $C_1$-$C_{12}$-Alkyl, $C_2$-$C_4$-Hydroxylalkyl, $C_3$-$C_8$-Alkoxyalkyl oder Cyclohexyl bedeutet und R Wasserstoff oder $C_1$-$C_4$-Alkyl ist,

Y' Wasserstoff, -COOH oder -$COOR^{11}$ ist oder Y und Y' zusammen -CO-O-CO- sind und

Z eine Gruppe der Formel

$$-CH_2-,\ -CH_2CH_2-,\ -C(CH_3)_2-,\ -\overset{\overset{\displaystyle O}{\|}}{C}-\ \text{oder}\ -O-\ \text{ist.}$$

2. Verfahren gemäss Anspruch 1, dadurch gekennzeichnet, dass man als Photoinitiator eine oder mehrere Verbindungen der Formeln I, II, III, IV oder V verwendet, worin Ar unsubstituiertes oder durch Chlor, $C_1$-$C_4$-Alkyl, Cl-$C_4$-Alkoxy, $C_1$-$C_4$-Alkylthio, 2-Hydroxyethylthio, Phenoxy, Phenylthio oder Benzoyl substituiertes $C_6$-$C_{10}$-Aryl ist, $R_1$, $R_2$, $R_3$, $R_4$, $R^5$ unabhängig voneinander H, Phenyl oder Methyl und $R^{1'}$, $R^{3'}$, $R^{4'}$ und $R^5$ Wasserstoff sind, X ein Rest $-N(R^6)(R^7)$, -OR oder $-OSi(R^9)_3$ ist, worin $R^6$ und $R^7$ unabhängig voneinander H, $C_1$-$C_4$-Alkyl, $C_3$-$C_5$-Alkenyl oder beide Reste zusammen $C_3$-$C_5$-Alkylen, das durch -O- oder $-N(CH_3)$-unterbrochen sein kann, bedeuten, $R^8$ Wasserstoff, $C_1$-$C_{19}$-Alkyl, $C_3$-$C_5$-Alkenyl, Benzyl oder 2-Tetrahydropyranyl bedeutet und $R^9$ Methyl oder Phenyl bedeutet, Y ein Rest -CN oder $-COOR^{11}$ und Y' Wasserstoff oder $-COOR^{11}$ ist, wobei R $C_1$-$C_4$-Alkyl bedeutet, und Z eine Gruppe der Formel $-CH_2-$, $-CH_2CH_2-$, $-C(CH_3)_2-$ oder -O- ist.

3. Verfahren gemäss Anspruch 1, dadurch gekennzeichnet, dass man als Photoinitiator eine oder mehrere Verbindungen der Formeln I, II oder IV verwendet, worin Ar Phenyl oder durch Cl, $CH_3$, $-CCH_3$, $-SCH_3$, Phenoxy oder Benzoyl substituiertes Phenyl ist, $R^1$, $R^2$, $R^3$, $R^4$ und $R^5$ unabhängig voneinander Wasserstoff oder Methyl und $R^{1'}$, $R^{3'}$, $R^{4'}$ und $R^{5'}$ Wasserstoff sind, X ein Rest $-N(R^6)(R^7)$, $-OR^8$ oder $-OSi(R^9)_3$ ist, worin $R^6$ und $R^7$ $C_1$-$C_4$-Alkyl oder $R^6$ und $R^7$ zusammen $C_3$-$C_5$-Alkylen, das durch -O- oder $-N(CH_3)$- unterbrochen sein kann, bedeuten, $R^8$ Wasserstoff, Methyl, Allyl oder Benzyl und $R^9$ Methyl ist und Z eine Gruppe der Formel $-CH_2-$, $-CH_2CH_2-$, oder -O- ist.

4. Verfahren gemäss Anspruch 3, dadurch gekennzeichnet, dass man als Photoinitiator eine oder mehrere Verbindungen der Formel I oder IV verwendet, worin X Hydroxyl ist und die übrigen Substituenten die in Anspruch 3 gegebene Bedeutung haben.

5. Verfahren gemäss Anspruch 1, dadurch gekennzeichnet, dass die Photopolymerisation durch Bestrahlen mit UV-Licht bewirkt wird.

6. Photopolymerisierbares Gemisch enthaltend eine oder mehrere monomere oder oligomere äthylenisch ungesättigte Verbindungen und einen Photoinitiator gemäss Anspruch 1.

7. Photopolymerisierbares Gemisch gemäss Anspruch 6, enthaltend ein Pigment, als Druckfarbe.

8. Druckfarbe gemäss Anspruch 7, enthaltend als Photoinitiatoren eine Verbindung der Formel I, II, III oder IV worin X ein Rest $-N(R^6)(R^7)$ ist, Ar ein durch -OH, $C_1$-$C_4$-Alkoxy, Phenoxy, -SH, $C_1$-$C_4$-Alkythio, 2-Hydroxyethylthio substituiertes Phenyl ist $R^1$, $R^{1'}$, $R^2$, $R^3$, $R^{3'}$, $R^4$, $R^{4'}$, $R^5$, $R^{5'}$, $R^6$, $R^7$ und Z die in Anspruch 1 gegebenen Bedeutungen haben.

9. Photopolymerisierbares Gemisch nach Anspruch 6, enthaltend 0,1 bis 20 Gew.-%, insbesondere 0,5 bis 5 Gew.-% Photoinitiator, bezogen auf die photopolymerisierbaren Verbindungen.

10. Verbindungen der Formeln I, II, III, IV oder V des Anspruchs 1, mit Ausnahme der Verbindung der Formel 1, worin Ar Phenyl ist, X -OH oder $-OSi(CH_3)_3$ ist, $R^3$ Methyl ist und $R^1$, $R^{1'}$, $R^2$, $R^{3'}$, $R^4$, $R^{4'}$, $R^5$ und $R^{5'}$ Wasserstoff sind.

## Claims

1. A process for the photopolymerisation of unsaturated compounds in the presence of a photoinitiator selected from the series consisting of the aroyl compounds, which process comprises using, as the photoinitiator, one or more compounds of the formula I, II, III, IV or V

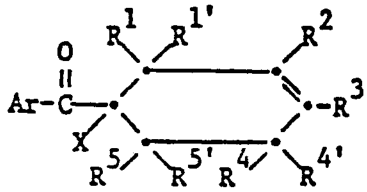 I 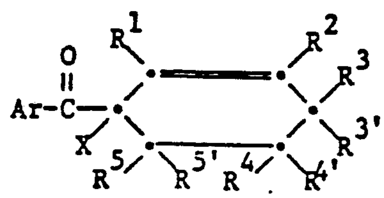 II

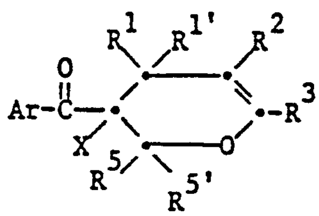 III 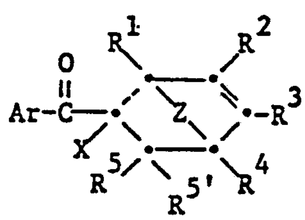 IV

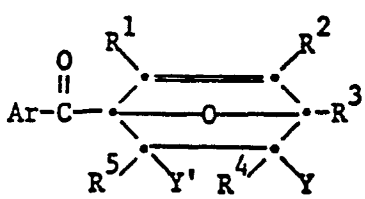 V

in which formulae Ar is $C_6$-$C_{12}$-aryl, thienyl, pyridyl or furyl, each of which is unsubstituted or substituted by one or more of the radicals halogen, phenyl, $C_1$-$C_{12}$-alkyl, $C_5$-$C_8$-cycloalkyl,-OH, $C_1$-$C_4$-alkoxy, phenoxy, -SH, $C_1$-$C_4$-alkylthio, phenylthio, 2-hydroxyethylthio, $C_2$-$C_5$-alkanoylamino, benzoylamino, $C_2$-$C_{12}$-dialkylamino, pyrrolidino, piperidino, morpholino, 4-methyl-piperazino or benzoyl, each of $R^1$, $R^{1'}$, $R^2$, $R^3$, $R^{3'}$, $R^4$, $R^{4'}$, $R^5$ and $R^5$ independently is H, $C_1$-$C_8$-alkyl, phenyl or $C_3$-$C_8$-alkenyl, X is a radical $-N(R^6)$ $(R^7)$, $-OR^8$ or $-OSi(R^9)_2$ $(R^{10})$, in which formulae each of $R^6$ and $R^7$ independently of the other is H, $C_1$-$C_{12}$-alkyl, or $C_2$-$C_4$-alkyl, $C_3$-$C_5$-alkenyl, cycloalkyl, $C_7$-$C_9$-phenylalkyl or phenyl, each of which is substituted by OH, $C_1$-$C_{12}$-alkoxy, $C_2$-$C_5$-carboalkoxy or CN, or $R^6$ and $R^7$ together are $C_3$-$C_5$-alkylene which can be interrupted by -O- or $-N(CH_3)-$, $R^8$ is hydrogen, $C_1$-$C_{12}$-alkyl,$C_3$-$C_{12}$-alkoxyalkyl, $C_3$-$C_5$-alkenyl, benzyl, phenyl or 2-tetra-hydropyranyl and $R^9$ and $R^{10}$ are $C_1$-$C_4$-alkyl or phenyl, Y is hydrogen, -CN, -COOH, $-COOR^{11}$, $-CO-R^{12}$ or -CO-phenyl, $R^{11}$ being $C_1$-$C_{12}$-alkyl, $C_2$-$C_4$-hydroxyalkyl, $C_3$-$C_8$alkoxyalkyl or cyclohexyl and $R^{12}$ being hydrogen or $C_1$-$C_4$-alkyl, Y' is hydrogen, -COOH or $-COOR^{11}$, or Y and Y' together are -CO-O-COand Z is a group of the formula $-CH_2-$, $-CH_2CH_2-$, $-C(CH_3)_2-$,

$-\overset{O}{\overset{\|}{C}}-$ or $-O-$.

2. A process according to claim 1, wherein the photoinitiator is one or more compounds of the formula I, II, II, IV or V, in which formulae Ar is $C_6$-$C_{10}$-aryl which is unsubstituted or substituted by chlorine, $C_1$-$C_4$alkyl, $C_1$-$C_4$-alkoxy, $C_1$-$C_4$-alkylthio, 2-hydroxyethylthio, phenoxy, phenylthio or benzoyl, each of $R^1$, $R^2$, $R^3$, $R^4$ and $R^5$ independenthy is H, phenyl or methyl and $R^{1'}$, $R^{3'}$, $R^{4'}$ and $R^{5'}$ are hydrogen, X is a radical $-N(R^6)(R^7)$, $-OR^8$ or $-OSi(R^9)_3$, in which formulae each of $R^6$ and $R^7$ independently of the other is H, $C_1$-$C_4$-alkyl or $C_3$-$C_5$-alkenyl, or the two radicals together are $C_3$-$C_5$-alky-lene which can be interrupted by -O- or $-N(CH_3)-$, $R^8$ is hydrogen, $C_1$-

$C_{12}$-alkyl, $C_3$-$C_5$-alkenyl, benzyl or 2-tetrahydro-pyranyl and R is methyl or phenyl, Y is a radical -CN or -$COOR^{11}$ and Y' is hydrogen or -$COOR^{11}$, $R^{11}$ being $C_1$-$C_4$-alkyl, and Z is a group of the formula -$CH_2$-, -$CH_2CH_2$-, -$C(CH_3)_2$- or -O-.

3. A process according to claim 1, wherein the photoinitiator is one or more compounds of the formula I, II or IV, in which formulae Ar is phenyl or phenyl which is substituted by Cl, $CH_3$, -$OCH_3$, -$SCH_3$, phenoxy, or benzoyl, each of $R^1$, $R^2$, $R^3$, $R^4$ and $R^5$ independently is hydrogen or methyl and $R^{1'}$, $R^{3'}$, $R^{4'}$ and $R^{5'}$ are hydrogen, X is a radical -$N(R^6)(R^7)$, -OR or -$OSi(R^9)_3$= in which formulae $R^6$ and $R^7$ are $C_1$-$C_4$-alkyl, or $R^6$ and $R^7$ together are $C_3$-$C_5$-alkylene which can be interrupted by -O- or -$N(CH_3)$-, R is hydrogen, methyl, allyl or benzyl and $R^9$ is methyl and Z is a group of the formula -$CH_2$-, -$CH_2CH_2$- or -O-.

4. A process according to claim 3, wherein the photoinitiator is one or more compounds of the formula I or IV, in which formulae X is hydroxyl and the remaining substituents have the meaning given in claim 3.

5. A process according to claim 1, wherein the photopolymerisation is effected by irradiation with UV light.

6. A photopolymerisable mixture containing one or more monomeric or oligomeric, ethylenically unsaturated compounds and a photoinitiator according to claim 1.

7. A photopolymerisable mixture according to claim 6, containing a pigment, as a printing ink.

8. A printing ink according to claim 7, containing, as photoinitiators, a compound of the formula I, II, III or IV, in which formulae X is a radical -$N(R^6)(R^7)$, Ar is phenyl which is substituted by -OH, $C_1$-$C_4$-alkoxy, phenoxy, -SH, $C_1$-$C_4$-alkylthio or 2-hydroxyethylthio, $R^1$, $R^{1'}$, $R^2$, $R^3$, $R^{3'}$, $R^4$, $R^{4'}$, $R^5$, $R^{5'}$, $R^6$ and $R^7$ and Z are as defined in claim 1.

9. A photopolymerisable mixture according to claim 6, containing 0.1 to 20% by weight, in particular 0.5 to 5% by weight, of photoinitiator, based on the photopolymerisable compounds.

10. A compound of the formula I, II, III, IV or V of claim 1 with the exception of the compound of the formula I in which Ar is phenyl, X is -OH or -$OSi(CH_3)_3$, $R^3$ is methyl and $R^1$, $R^{1'}$, $R^2$, $R^{3'}$, $R^4$, $R^{4'}$, $R^5$ and $R^{5'}$ are hydrogen.

**Revendications**

Procedé de photopolymérisation de composés insaturés en présence d'un photoinitiateur de la famille des composés aroyle, caractérisé en ce que l'on utilise comme photoinitiateur un ou plusieurs des composés des formules I, II, III, IV ou V ci-dessous

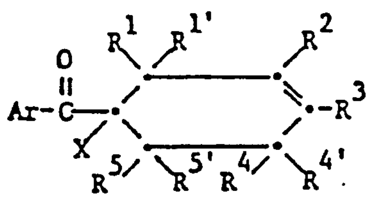
I

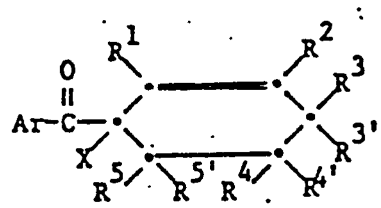
II

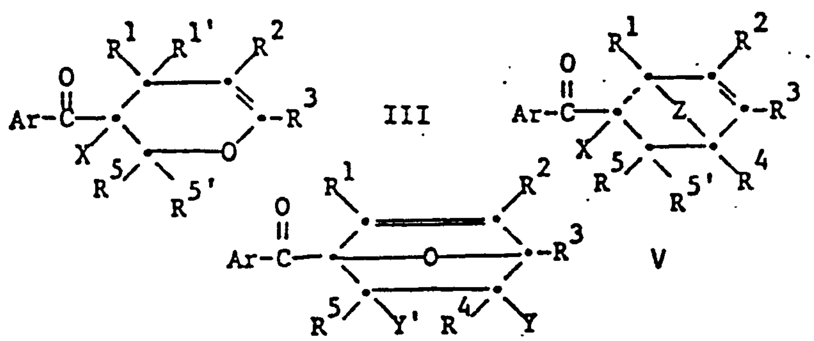
III IV V

dans lesquelles:

Ar représente un groue furyle ou pyridyle ou thiényle, ou aryle en $C_6$-$C_{12}$, non substitué ou bien substitué par un ou plusieurs des radicaux suivants: halogène, phényle, alkyle en $C_1$-$C_{12}$, cycloalkyle en $C_5$-$C_8$, -OH, alcoxy en $C_1$-$C_4$, phénoxy, -SH, alkylthio en $C_1$-$C_4$, phénylthio, 2-hydroxy-éthylthio, alcanoyl-amino en $C_2$-$C_5$,

benzoylamino, dialkylamino en $C_2$-$C_{12}$, pyrrolidino, pipéridino, morpholino, 4-méthyl-pipérazino, ou benzoyle;

$R^1$, $R^{1'}$, $R^3$, $R^{3'}$, $R^4$, $R^{4'}$, $R^5$ et $R^{5'}$représentent

indépendamment les uns des autres un atome d'hydrogène, ou un groupe-alkyle en $C_1$-$C_8$, ou phényle, ou alcényle en $C_3$-$C_8$;

X représente un radical -N($R^6$) ($R^7$), -$OR^8$ ou -OSi($R^9$)$_2$($R^{10}$) dans lequel $R^6$ et $R^7$ représentent indépendamment l'un de l'autre un radical H, un radical alkyle en $C_1$-$C_{12}$, ou un radical phényle, ou phénylalkyle en $C_7$-$C_9$, un cycloalkyle ou alcényle en $C_3$-$C_5$ ou alkyle en $C_2$-$C_4$, substitué par un groupe OH alcoxy en $C_1$-C $_2$, carbalcoxy en $C_2$-$C_5$ ou un groupe CN, ou bien $R^6$ et $R^7$ représentent ensemble un groupe alkylène en $C_3$-$C_5$ pouvant être interrompu par un pont oxygène -O- ou par un groupe -N($CH_3$)- $R^8$ représente un atome d'hydrogène, un radical alkyle en $C_1$-$C_{12}$, un radical alcoxyalkyle en $C_3$-$C_{12}$, un radical alcényle en $C_3$-$C_5$, un radical benzyle, un radical phényle, ou un radical 2-tétrahydropyrinnyle et $R^9$ et $R^{10}$ représentent un groupe phényle ou alkyle en $C_1$-$C_4$;

Y représente un atome d'hydrogène, ou ungroupe -CN, -COOH, -$COOR^{11}$, -CO-$R^{12}$ ou -CO-phényle, le groupe $R^{11}$ représentant un radical alkyle en $C_1$-$C_{12}$, hydroxyalkyle en $C_2$-$C_4$, alcoxyalkyle en $C_3$-$C_8$ ou cyclohexyle, et le radical $R^{12}$ représentant un atome d'hydrogène ou un groupe alkyle en $C_1$-$C_4$

Y' représente un atome d'hydrogène ou un groupe -COOH ou -$COOR^{11}$, ou bien Y et Y' représentent ensemble le groupe -CO-O-CO- et;

Z représente un groupe de formule -$CH_2$-, -$CH_2CH_2$-, -C($CH_3$)$_2$-,

$$-C(CH_3)_2-, \quad -\underset{\underset{O}{\|}}{C}- \quad ou \quad -O- .$$

2.- Procédé selon la revendication I, caractérisé en ce que l'on utilise comme photoinitiateur un ou plusieurs composés des formules I, II, III IV ou V dans lesquelles Ar représente un groupe aryle en $C_6$-$C_{10}$ non substitué ou substitué par un atome de chlore, un groupe alkyle en $C_1$-$C_4$, alcoxy en $C_1$-$C_4$, alkylthio en $C_1$-$C_4$, 2-hydroxyéthylthio, phénoxy, phénylthio, ou benzoyle, $R^1$, $R^2$, $R^3$, $R^4$, $R^5$, indépendamment les uns des autres, représentent un atome d'hydrogène, un groupe phényle ou un groupe méthyle, et $R^1$, $R^3$, $R^4$ et $R^5$ representent un atome d'hydrogène, X représente un radical -N($R^8$)($R^7$), -$OR^8$ ou -OSi($R^8$)$_3$, $R^8$ et $R^7$ représentant, indépendamment l'un de l'autre, un atome d'hydrogène, ou un groupe alkyle en $C_1$-$C_4$, alcényle en $C_3$-$C_5$, ou bien les deux radicaux représentent ensemble un groupe alkylène en $C_3$-$C_5$, qui peut être interrompu par un groupe -O- ou -N($CH_3$)-, et $R^8$ représente un atome d'hydrogène, ou un groupe alkyle en $C_1$-$C_{12}$, alcényle en $C_3$-$C_5$, benzyle ou 2-tétrahydropyrannyle et $R^9$ représente un groupe méthyle, ou phényle, Y représente un groupe -CN ou -$COOR^{11}$ et Y' représente un atome d'hydrogène ou un groupe -$COOR^{11}$, $R^{11}$ représentant un groupe alkyle en $C_1$-$C_4$ et Z représentant un groupe de formule: -$CH_2$-, -$CH_2CH_2$-, -C($CH_3$)$_2$- ou -O-.

3.- Procédé selon la revendication 1, caractérisé en ce que l'on utilise comme photoinitiateur un ou plusieurs des composés de formules I, II ou IV dans lesquels Ar représente un groupe phényle ou un radical phényle substitué par Cl, $CH_3$ -$OCH_3$ -$SCH_3$ phénoxy ou benzoyle, $R^1$, $R^3$, $R^4$, et $R^5$ représentent, indépendamment les uns des autres, un atome d'hydrogène ou un groupe méthyle, et $R^{1'}$, $R^{3'}$, $R^{4'}$et $R^{5'}$représentent un atome d'hydrogène, X représente un radical -N($R^6$)($R^7$), -$OR^8$ ou OSi($R^9$)$_3$, $R^6$ et $R^7$ représentant un radical alkyle en $C_1$-$C_4$ ou $R^6$ et $R^7$ représentent ensemble un groupe alkylène en $C_3$-C5 qui peut être interrompu par un groupe -O- ou -N($CH_3$)-, R represente un atome d'hydrogène, ou un groupe méthyle, allyle ou benzyle, et $R^9$ représente un groupe méthyle, et Z représente un groupe de formule -$CH_2$-, -$CH_2CH_2$- ou -O-.

4.- Procédé selon la revendication 3, caractérisé en ce que l'on utilise comme photoinitiateur un ou plusieurs composés de formules I ou IV dans lesquelles X représente un groupe hydroxy et les autres substituants sont tels que définis dans la revendication 3.

5.- Procédé selon la revendication 1, caractérisé en ce que l'on effectue la photopolymérisation par irradiation à la lumière UV.

6.- Mélange photopolymérisable contenant un ou plusieurs composés à insaturation éthylénique, monoméres ou oligomères, et un photoinitiateur selon la revendication 1.

7.- Mélange photopolymérisable selon la revendication 6, contenant un pigment, en tant qu'encre d'imprimerie.

8.- Encre d'imprimerie selon la revendication 7 contenant comme photoinitiateur un composé de formule I, II, III ou IV, dans laquelle X représente un radical -N($R^6$)$R^7$), Ar représente un groupe phényle substitué par un groupe -OH alcoxy en $C_1$-$C_4$, phénoxy, -SH, alkylthio en $C_1$-$C_4$ ou 2-hydroxyéthylthio, et $R^1$, $R^{1'}$, $R^2$, $R^3$, $R^{3'}$, $R^4$, $R^{4'}$, $R^5$ R', $R^6$ $R^7$ et Z sont tels que définis dans la revendication 1.

9.- Mélange photopolymérisable selon la revendication 6, contenant de 0,1 à 20 % en poids, en particulier de 0,5 à 5 % en poids de photoinitiateur, par rapport aux composés photopolymérisables.

10.- Composés répondant aux formules I, II, III, IV ou V selon la revendication 1, à l'exclusion du composé de formule 1 dans laquelle Ar représente un groupe phényle X représente un groupe -OH ou -OSi ($CH_3$)$_3$, $R_3$ représente un groupe méthyle et les radicaux $R^1$, $R^{1'}$, $R^2$, $R^{3'}$, $R^4$, $R^{4'}$, $R^5$ et R', représentent un atome d'hydrogène.